# EUROPEAN PATENT APPLICATION

(11) **EP 1 729 179 A1**
(43) Date of publication of application: **06.12.2006**
(21) Application number: 05012012.0
(22) Date of filing: 03.06.2005
(51) Int. Cl.: G03F 7/42

(54) **Method for fine line resist stripping**

(71) Applicant: ATOTECH Deutschland GmbH, 10553 Berlin (DE)
(72) Inventor: Sparing, Christian, 13509 Berlin (DE); Tews, Dirk, 10439 Berlin (DE); Wood, Neal, Worcestershire B98 8HX (GB)
(74) Representative: Albrecht, Thomas

(57) **Abstract**

The invention relates to a 2-step stripping process comprising the following stripping steps:
a) treating the substrate with an aqueous solution containing a base,
b) thereafter further treating the substrate with a solution containing a base and at least one stripping enhancer selected from the group consisting of
(i) quartemary ammonium salts,
(ii) triazoles, benzotriazoles, imidazoles, tetrazoles,
(iii) water soluble organic solvents, which are not bases.

## Description

### Description of the invention

The present invention relates to a method for stripping of dryfilm and photoresist material from a substrate. The substrate generally is a semiconductor-device or a printed circuit board.

### Background of the invention

Integrated circuit manufacturing technology utilizes positive photoresist type material for photolithographically delineating patterns on substrates which later on in the process are etched by wet or dry etching techniques.

Imaging is the process that patterns the metal conductor to form the circuit. This process involves a multistep integration of imaging materials, imaging equipment, and processing conditions with the metallization process to reproduce the master pattern on a substrate. Large features (200 µm and greater) can be very economically formed by screen printing. Feature sizes smaller than 200 µm, however, are formed using a photolithographic process. As circuit densities have increased over the years, the imaging process has continually evolved to enable commercial production of finer features. This need for high-density interconnect (HDI) is driving the industry with feature sizes of 50 µm or lower. Imaging equipment and materials have been developed to meet this challenge.

The photolithographic process sequence for imaging basically involves applying a light-sensitive polymeric material (photoresist) onto the substrate of interest, exposing this photoresist to light with the desired pattern, and developing the exposed pattern. This developed pattern is used for either subtractive (etching) or additive (plating) metal pattern transfer. After metallization, the photoresist is stripped from the surface and the panel is ready for further processing.

It is necessary in such a full lithographic process that the photoresist material, following pattern delineation, be evenly and completely removed from all exposed and unexposed areas so as to permit further operations. Even the partial remains of a resist coating in an area to be processed is undesirable as the left over residue of the photoresist material can have a detrimental effect on the yield of acceptable integrated circuits.

The complete removal of the photoresist after pattern transfer is accomplished in 1 M or greater solutions of sodium or potassium hydroxide at elevated temperatures, often with an antitarnishing additive to limit oxidation of the copper. Thus, in general, these materials exhibit excellent stability in acidic solution, but they do have varying stability to more strongly acid and alkaline solutions. In fact, there are subclasses of materials: for acid etching of copper and for alkaline (ammoniacal usual) etching of copper. Increased acid stability is required for use in acid copper plating in which the pHs of the solutions often are below 1.

Additionally resist materials can be removed by one or more of the following:
halogenated hydrocarbons, such as methylene chloride, amines and their derivatives, such as dimethylsulfoxide, dimethylformamide, N-methyl-2-pyrrolidinone, glycol ethers, such as ethylene glycol monomethyl ether, ethanol, ketones, such as methylethyl ketone and acetone and materials, such as isopropyl alcohol, sulphuric acid, ammonium persulfate and mixtures of caustic and phenol derivatives, as well as various other materials.

Dry-film photoresists are generally used for pattern formation prior to both plating and etching. These films have a three-layer structure, with the photosensitive material sandwiched between a polyester coversheet and a polyethylene separator sheet.

Liquid photoresists come in a variety of chemistries. Many are simply coatable forms of the dry-film materials. They have been used primarily for patterning innerlayers and are applied to the substrate by roller, spray, curtain, or electrostatic coating techniques. Applied thickness is typically 6 to 15 µm, giving superior resolution compared to dry-film resists that are generally thicker. Since resolution is approximated by the thickness, they have the potential to resolve features less than 25 µm. Conformation of liquid photoresist to the copper substrate is generally very good, and it is possible to achieve high yield at 50 µm features and less.

Alkali-soluble resist inks are generally preferred. Stripping in the case of thermal and UV-curable resists is accomplished in 2 weight % sodium hydroxide or in proprietary solutions. The resist is loosened and rinsed off with a water spray. Adequate safety precautions must be taken, since caustics are harmful. Conveyorized resist-stripping and etching machines use high-pressure pumping systems that spray hot alkaline solutions on both sides of the boards. Certain laminate materials such as the polyimides may be attached by alkaline strippers. Measling, staining, or other degradation is noted when strippers attack epoxy or other substrates. Control of concentration, temperature, and dwell time usually can prevent serious problems. Screened vinyl-based resists are removed by a dissolving action in solutions of chlorinated, petroleum, or glycol ether solvents. Methylene chloride and toluene (both currently not usable) were used extensively in cold stripper formulations.

WO 95/23999 discloses aqueous compositions for removing polymer resist layers containing a base and a soluble silicate, for example ethanol amine and sodium orthosilicate (Example 2) or potassium hydroxide and sodiumsilicate (Example 4).

US 5,102,777 describes a photoresist stripper composition containing an amine and a fatty acid.

The common equipment for stripping is spray conveyorized, either horizontally or vertically. Additives are used in the developer solutions to prevent foaming.

The stripping solution swells and dissolves the photoresist, stripping it either in sheets or as small particles. The equipment design must effectively remove and separate the skins. Often, brushes and ultrasonic agitation are added to aid in the resist removal. As with developing, filtration is important to keep the spray nozzles clean and keep fresh solution reaching the panel. For stripper chemistries that oxidize the copper, an antitamishing agent is often added either to the stripping solution or as part of the rinsing.

One problem with the use of such photoimageable compositions as photoresists is that they are difficult to strip from electrolytically plated circuit boards using conventional alkaline aqueous stripping solutions, e.g., 3 weight % NaOH solution. This problem arises from the recent demand on circuit board manufacturers to reduce the size of printed circuit boards, while also increasing their functional capabilities. Consequently, the circuit lines and spaces on the circuit boards have continued to shrink, as more circuitry needs to be fit onto smaller surfaces.

This applies particularly to fine line high-density interconnect (HDI) feature sizes of 50 µm and today even 25 µm or lower. The sizes particular relate to the US value. The US value determines the width of a conductor track (L) and the space (S) between two conductor tracks. Fine line applications are typically described by L/S-vaiues of 50 µm or lower for the L and S-value, more particular 25 µm or lower for the L and S-value. Although in most cases, the L and S value are the same, also values of 50 µm / 25 µm, 30 µm / 25 µm, 25 µm / 50 µm etc. are possible.

The majority use organic-based (amine- or organic solvent-containing) alkaline stripping solutions, which produce a smaller stripped particle to facilitate stripping. While these organic strippers, e.g., solutions containing trimethylamine or tetramethylammonium hydroxide, remove the resist better, they are expensive (relative to NaOH or KOH) and have more waste treatment and environmental concerns associated with them. Moreover, due to the recent emphasis on reducing solvent emissions in the workplace, solvent-strippable photoresists are much less desirable than those that are aqueous-strippable.

EP 1 043 629 describes a photoresist stripping composition comprising a nitrogen-containing organohydroxyl compound, an alkylene glycol monoalkyl ether represented by the general formula: HO-(CpH2pO)q-R, wherein R is C1-C4 alkyl, p is 2 or 3, and q is 1, 2 or 3, sugar or sugar alcohol, a phosphorus-containing compound and water.

It is an object of the present invention to provide a method for efficient and residue-free removal of photoresist films on a substrate, particular suitable for fineline photoresist films featuring sizes of 50 µm, preferably 25 µm or lower.

It is a further object of the invention to enhance the lifetime of solutions applied particularly suited for fineline stripping.

Thus, the present invention applies a 2-step stripping process comprising the following stripping steps:
a) treating the substrate with an aqueous solution containing a base,
b) thereafter further treating the substrate with a solution containing a base and at least one stripping enhancer selected from the group consisting of
   (i) quartemary ammonium salts,
   (ii) triazoles, benzotriazoles, imidazoles, tetrazoles,
   (iii) water soluble organic solvents, which are not bases.
to achieve complete removal of the photoresist film while at the same time enhancing the lifetime of the more valuable fineline stripping solution.

Pre- and post-treatment steps like rinsing etc. may be applied to further improve the stripping results.

The first stripping solution contains a base, preferably a metal hydroxide like sodium or potassium hydroxide. The content of the hydroxide is 0.05 - 15 weight %, preferably 1 - 5 weight %.

As a base, also amines may be used.

Examples of such amines comprise amines of the general formula

NR₃R₄R₅

wherein R₃, R₄ and R₅ are the same or different and are hydrogen or alkyl or hydroxyalkyl groups of 1 to 18 carbon atoms, phenyl, alkylphenyl or hydroxyalkylphenyl wherein the alkyl is of 1 to 18 carbon atoms. Specific examples of amines include trimethyl amine, triethyl amine, benzyl dimethyl amine, phenyl dimethyl amine, dodecyl dimethyl amine, hexadecyl dimethyl amine, octadecyl dimethyl amine, dodecyl diethyl amine, hexadecyl diethyl amine, octadecyl diethyl amine, dodecyl di-n-propyl amine, dodecyl di-isopropyl amine, benzyl methyl hexadecyl amine, methyl ethyl hexadecyl amine, p-dodecylbenzyl dimethyl amine, and benzyl methyl octadecyl amine.

Examples for preferred alkanolamines comprise triethanol amine, diethanol amine, dipropyl amine, methanol diethanol amine, propanol diethanol amine and propanol ethanol amine.

The content of the amine is 0.05 - 35 weight %, preferably 1 - 10 weight %.

Optionally, the stripping solution additionally contains a soluble silicate, for example sodium orthosilicate or sodium silicate. Optionally, also copper complexing agents like sodium gluconate, sodium phosphonate, EDTA etc. may be applied.

The solution is sprayed onto the substrate having the photoresist film on its surface at a pressure of 1.0 - 10.0 bar, preferably 1.5 - 5.0 bar and at a temperature of 30° - 90°C, preferably 40° - 70°C. Treating time is 10 seconds - 10 minutes, preferably 30 seconds - 3 minutes. Thereafter, the substrate is preferably rinsed in water. Investigation with a Fluorescene Microscope at a 200-fold magnification shows that although most of the photoresist film has been removed, residues remain on the substrate in an amount not tolerable for further processing.

The substrate is then treated in a second stripping solution which contains again a base and additionally a stripping enhancer.

The base can be selected from hydroxides and amines according to step 1 a) of the process and described in detail above. In case the stripping enhancer is a quaternary ammonium salt, a triazole, benzotriazol, imidazole or tetrazole, amines are preferably utilized as bases. When choosing water soluble organic solvents, which are not bases as a stripping enhancer, hydroxides as bases are preferred.

The quaternary ammonium salts have the general formula

NR₁R₂R₃ R₄X,

wherein R₁, R₂ and R₃ and R₄ are the same or different and are selected from the group consisting of alkyl, hydroxyalkyl, phenyl, alkylphenyl and hydroxyalkylphenyl, wherein alkyl has 1 to 18 carbon atoms and wherein X is selected from the group consisting of anions, preferably hydroxide, sulfate and halide. Preferred examples of quaternary ammonium salts are tetramethylammonium hydroxide, choline hydroxide, and trishydroxyethylmethylammonium hydroxide. A preferred imidazole compound is benzimidazole. 5-aminotetrazole, 5-phenyltetrazole, benzotriazole, methylbenzotriazole and ethylbenzotriazole are also preferred compounds.

Preferred water soluble organic solvents, which are not bases are not volatile at process temperatures and possess boiling points higher than 90°C. Examples comprise pyrrolidones like NMP (N-methylpyrrolidon), alkyl alcohols like 1-butanole, 2-butanole,1-pentanol, butylcarbitole. Glycols like ethylene glycole, propylene glycol, butyl glycole and glycol ethers like ethylene glycol monoethyl ether, ethylene glycol monobutyl ether, propylene glycol monomethyl ether, propylene glycol monoethyl ether, propylene glycol monobutyl ether, diethylene glycol monomethyl ether, diethylene glycol monoethyl ether, diethylene glycol monopropyl ether, diethylene glycol monobutyl ether, dipropylene glycol monomethyl ether, dipropylene glycol monoethyl ether, dipropylene glycol monopropyl ether, dipropylene glycol monobutyl ether, triethylene glycol monomethyl ether, triethylene glycol monoethyl ether, triethylene glycol monopropyl ether, triethylene glycol monobutyl ether, tripropylene glycol monomethyl ether, tripropylene glycol monoethyl ether, tripropylene glycol monopropyl ether and tripropylene glycol monobutyl ether diethylenglycolmonoisopropyl ether, propylenglycolmonomethyl ether acetate and diethylenglycolmonobutyl ether are most preferred.

The solution according to process step b) is sprayed onto the substrate having the photoresist film on its surface at a pressure of 1.0 - 10.0 bar, preferably 1.5 - 5.0 bar and at a temperature of 30° - 90°C, preferably 40° - 70°C. Treating time is 0.5 - 10 minutes, preferably 0.5 - 3 minutes.

### The invention is further explained by the following examples:

The sample boards are BGA coupons coated with the Dryfilm resist-type Morton SIT 2025 . The Sample A has a resolution of 30 µm US and the Sample B has a resolution of 15 µm US.

Both samples were investigated after the resist stripping with a fluorescence microscope on resist residues and visible inspection on surface cosmetics.

### Example 1 (comparative):

The Sample A is sprayed at 1.5 bar with a solution consisting of 30 g/l KOH in water at 60°C for 1 min. Some parts of the resist coating are stripped in sheets from the sample into the stripper solution. After rinsing and drying the sample is investigated with a fluorescence microscope at a 200 x magnification. As a result, the Sample A shows resist residues all over. The stripping results are unsatisfactory. A cascade of further treatment steps is required in order to remove at least the majority of resist film on the board surface. Even then, stripping is not complete.

### Example 2 (comparative):

Sample A is sprayed at 1.5 bar with a solution consisting of 30 g/l monoethanolamine, 5 g/l tetramethylammoniumhydroxide and 5 g/l cholinehydroxide and 0.5 g/l benzotriazole in water at 60°C for 1 min. The resist is stripped from the sample in 4 - 5 mm particles into the solution. After rinsing and drying the sample is investigated with a fluorescence microscope at 200 x magnification. As a result, the Sample A shows some resist residue particles left and a good copper surface cosmetics in the stripped areas. However, the stripping results are unsatisfactory. A cascade of further treatment steps is required in order to remove at least the majority of resist film on the board surface. Even then, stripping is not complete.

### Example 3:

Sample A is sprayed at 1.5 bar in a first step with a solution consisting of 30 g/l KOH in water at 60°C for 1 min. After that the Sample A is sprayed at 1.5 bar in a second step with a solution consisting of 30 g/l monoethanolamine, 5 g/l tetramethylammoniumhydroxide and 5 g/l cholinehydroxide and 0.5 g/l benzotriazole in water at 60°C for 1 min. The resist is stripped from the Sample A in sheets into the stripper solution during the first step and in 3 - 4 mm particles during the second step into the stripper solution. After rinsing and drying the sample is investigated with a fluorescence microscope at a 200 x magnification. As a results the Sample A shows no resist residues and a good copper surface cosmetics in the stripped areas. One would consider the stripping result very succesful.

### Example 4:

Due to the fact that Sample B has a higher resolution, a residue free stripping like in Example 3 is impossible. Example 3 was repeated with the same condition except the spray pressure was set to 5 bar for both the first and the second step. After rinsing and drying the sample is investigated with a fluorescence microscope at 200 x magnification The resist is stripped from the Sample A in sheets into the stripper solution during the first step but was reduced to 1 - 2 mm particles during the second step into the stripper solution. As a results the Sample B shows no resist residues at all and provides an excellent copper surface cosmetic without signs of oxidation, corrosion or stains.

### Example 5:

Sample B is sprayed at 1.5 bar in a first step with a solution consisting of 30 g/l KOH in water at 60°C for 1 min. After that the Sample A is sprayed at 1.5 bar in a second step with a solution consisting of 30 g/l KOH and 100 ml/l of diethylene glycol monobutyl ether in water at 60°C for 1 min. The resist is stripped from the Sample B in sheets into the stripper solution during the first step and in 0.5 - 1 mm particles during the second step into the stripper solution. After rinsing and drying the sample is investigated with a fluorescence microscope at a 200 x magnification. As a results the Sample A shows no resist residues and a good copper surface cosmetics in the stripped areas. One would consider the stripping result excellent.

## Claims

1. A method for the removal of photoresist films on a substrate comprising the following steps:
a) treating the substrate with an aqueous solution containing a base,
b) thereafter further treating the substrate with a solution containing a base and at least one stripping enhancer selected from the group consisting of
(i) quarternary ammonium salts,
(ii) triazoles, benzotriazoles, imidazoles, tetrazoles,
(iii) water soluble organic solvents, which are not bases.

2. The method according to claim 1 wherein the base contained in the solution used in step a) is a hydroxide, preferably sodium or potassium hydroxide.

3. The method according to claim 2 wherein the hydroxide is contained in the solution used in step a) in an amount of 0.05 to 15% by weight, preferably in an amount of 1 to 5% by weight.

4. The method according to claim 1 wherein the base contained in the solution used in step a) is an amine of the general formula
NR₃R₄R₅
wherein R₃, R₄ and R₅ are the same or different and are hydrogen or alkyl or hydroxyalkyl groups of 1 to 18 carbon atoms, phenyl, alkylphenyl or hydroxyalkylphenyl wherein the alkyl is of 1 to 18 carbon atoms.

5. The method according to claim 4 wherein the amine is selected from the group consisting of trimethyl amine, triethyl amine, benzyl dimethyl amine, phenyl dimethyl amine, dodecyl dimethyl amine, hexadecyl dimethyl amine, octadecyl dimethyl amine, dodecyl diethyl amine, hexadecyl diethyl amine, octadecyl diethyl amine, dodecyl di-n-propyl amine, dodecyl di-isopropyl amine, benzyl methyl hexadecyl amine, methyl ethyl hexadecyl amine, p-dodecylbenzyl dimethyl amine, and benzyl methyl octadecyl amine.

6. The method according to claim 4 wherein the amine is an alkanol amine selected from the group consisting of triethanol amine, diethanol amine, dipropyl amine, methanol diethanol amine, propanol diethanol amine and propanol ethanol amine.

7. The method according to the claims 4 to 6 wherein the solution contains the amine in an amount of 0.05 to 35 weight %, preferably 1 to 10 weight %.

8. The method according to any of the preceding claims wherein the solution in step a) additionally contains a soluble silicate, preferably sodium orthosilicate or sodium silicate.

9. The method according to any of the preceding claims wherein the solution in step a) additionally contains a copper complexing agent, preferably sodium gluconate, sodium phosphonate or EDTA.

10. The method according to any of the preceding claims wherein the solution in step a) is sprayed onto the substrate having the photoresist film on its surface at a pressure of 1.0 - 10.0 bar, preferably 1.5 - 5.0 bar and at a temperature of 30° - 90°C, preferably 40° - 70°C and a treating time of 10 seconds - 10 minutes, preferably 30 seconds - 3 minutes.

11. The method according to any of the preceding claims wherein the solution in step b) contains either a base according to the claims 2 to 3 or a base according to the claims 4 to 7.

12. The method according to any of the preceding claims wherein the stripping enhancers (i) are selected from the group consisting of at least one quartemary ammonium salt of the general formula
NR₁R₂R₃ R₄X
wherein R₁, R₂ and R₃ and R₄ are the same or different and are selected from the group consisting of alkyl, hydroxyalkyl, phenyl, alkylphenyl and hydroxyalkylphenyl, wherein alkyl has 1 to 18 carbon atoms and wherein X is selected from the group consisting of anions, preferably hydroxide, sulfate and halide.

13. The method according to claim 12 wherein the at least one quaternary ammonium salt is selected from the group consisting of tetramethylammonium hydroxide, choline hydroxide and trishydroxyethylmethylammonium hydroxide.

14. The method according to the claims 12 to 13 wherein the concentration of the at least one quaternary ammonium salt in the solution is 2% to 35 weight %, preferably 2% to 10 weight %.

15. The method according to any of the preceding claims wherein the stripping enhancers (ii) are selected from the group consisting of benzimidazole, 5-aminotetrazole, 5-phenyltetrazole, benzotriazole, methylbenzotriazole and ethylbenzotriazole.

16. The method according to any of the preceding claims wherein the water soluble organic solvents (iii), which are not bases are not volatile at process temperatures and possess boiling points higher than 90°C.

17. The method according to any of the preceding claims wherein the stripping enhancers (iii) are selected from the group consisting of pyrrolidones.

18. The method according to any of the preceding claims wherein the stripping enhancers (iii) are selected from the group consisting of alkyl alcohols.

19. The method according to any of the preceding claims wherein the stripping enhancers are selected from the group consisting of glycols.

20. The method according to any of the preceding claims wherein the stripping enhancers (iii) are selected from the group consisting of ethylene glycol monoethyl ether, ethylene glycol monobutyl ether, propylene glycol monomethyl ether, propylene glycol monoethyl ether, propylene glycol monobutyl ether, diethylene glycol monomethyl ether, diethylene glycol monoethyl ether, diethylene glycol monopropyl ether, diethylene glycol monobutyl ether, dipropylene glycol monomethyl ether, dipropylene glycol monoethyl ether, dipropylene glycol monopropyl ether, dipropylene glycol monobutyl ether, triethylene glycol monomethyl ether, triethylene glycol monoethyl ether, triethylene glycol monopropyl ether, triethylene glycol monobutyl ether, tripropylene glycol monomethyl ether, tripropylene glycol monoethyl ether, tripropylene glycol monopropyl ether and tripropylene glycol monobutyl ether diethylenglycolmonoisopropyl ether and propylene glycol monomethyl ether acetate.

21. The method according to any of the preceding claims wherein the solution in step b) is sprayed onto the substrate having the photoresist film on its surface at a pressure of 1.0 - 10.0 bar, preferably 1.5 - 5.0 bar and at a temperature of 30° - 90°C, preferably 40° - 70°C and a treating time of 0.5 - 10 minutes, preferably 0.5 - 3 minutes.

22. The method according to any of the preceding claims wherein a substrate is used having a L/S value of less than 50 µm, preferably of less than 25 µm for the L- and S-value.

23. The method according to any of the preceding claims wherein a printed circuit board is used as a substrate.
